# EUROPEAN PATENT APPLICATION

(11) **EP 1 739 107 A1**
(43) Date of publication of application: **03.01.2007**
(21) Application number: 06253282.5
(22) Date of filing: 23.06.2006
(51) Int. Cl.: C08F 220/02, D04H 1/64

(54) **Curable composition**

(30) Priority: 01.07.2005 US 696454 P
(71) Applicant: Rohm and Haas Company, Philadelphia, PA 19106-2399 (US)
(72) Inventor: Finch, William Christopher, Blue Bell Pennsylvania 19422 (US); Kelly, Michael Dewayne, North Wales, Pennsylvania 19454 (US)
(74) Representative: Kent, Venetia Katherine

(57) **Abstract**

A copolymer composition, useful as a thermosetting binder having carboxylic acid or anhydride, and hydroxy functionality on the same backbone.

## Description

This invention relates to a curable composition, useful as a thermosetting binder, by reacting, in situ, an ethylenically-unsaturated carboxylic acid, with the reaction product of an ethylenically-unsaturated carboxylic acid anhydride monomer and a hydroxy-functional compound.

Curable compositions containing little or no formaldehyde are highly desirable for use in the manufacture of a variety of products, due to the health and environmental problems commonly associated with formaldehyde, as well as existing and proposed legislation directed to the lowering or elimination of formaldehyde. There currently exist such formaldehyde-free systems that react a carboxylic acid polymer with a hydroxyl-containing compound. There also exist systems having improved cure efficiency, which incorporate the carboxylic acid and the hydroxyl functionality on the same polymer backbone, by copolymerizing a hydroxy-functional monomer with a carboxylic acid monomer. However, the use of hydroxy-functional acrylic monomers tends to be costly, as they are often made from expensive raw materials, and their synthesis typically involves a time-consuming purification step, and can require the input of high levels of energy, as the application of high temperatures is often necessary. It is therefore desirable to provide an alternative method for making a curable composition containing both carboxylic acid and hydroxy functionality on the same polymer backbone that does not require purification of a hydroxy-functional monomer, can use inexpensive raw materials, and can result in lower processing costs.

U.S. Patent No. 5,143,582 discloses the preparation of copolymers containing β-hydroxyalkylamides having a particular formula, and carboxy containing monomers to provide a self-curing polymer, but does not provide a method for preparing such polymers.

U.S. Patent Application No. 2004/0254290 discloses the preparation of a copolymer useful in glass adhesion, containing at least one acid functional monomer unit and at least one substituted amide, silanol, or amine oxide comonomer unit.

Applicants have discovered a substantially formaldehyde-free thermosetting resins which solves at least one of the above-mentioned problems, that has an ethylenically-unsaturated carboxylic acid anhydride monomer and a hydroxy-functional compound, with an ethylenically-unsaturated carboxylic acid monomer.

A first aspect of this invention is a curable copolymer composition comprising as monomer units:
(i) from 55 to 90 % by weight, based on the weight of said copolymer composition, of an ethylenically-unsaturated carboxylic acid monomer, and
(ii) from 10 to 30 % by weight, based on the weight of said copolymer composition, of a β-hydroxyalkylamide wherein the ratio of equivalents of said β-hydroxyalkylamide hydroxy functional groups to said carboxylic acid functional groups is from 0.05:1 to 1:1.

A second aspect of this invention is where the β-hydroxyalkylamide has been reacted in-situ with said ethylenically unsaturated carboxylic acid monomer.

A third aspect of this invention is where the alkanolamine is selected from the group consisting of primary alkanolamine, secondary alkanolamine, and polyol.

A fourth aspect of this invention is where the composition further comprises at least one hydroxy-functional compound.

A fifth aspect of this invention is where the anhydride and said alkanolamine have been reacted in the presence of an auxiliary base.

A sixth aspect of this invention is where the alkanolamine has a molecular weight of no greater than 1,000.

A seventh aspect of this invention is where the alkanolamine compound is not ethylenically-unsaturated .

An eighth aspect of this invention is where the composition further comprises a phosphorous-containing accelerator such as disclosed in U.S. Patent No. 6,136,916.

A ninth aspect of this invention is where the composition further comprises an emulsion polymer including, as polymerized units, greater than 30%, based on the weight of the emulsion polymer solids, of an ethylenically-unsaturated acrylic monomer including a C₅ or greater alkyl group.

A tenth aspect of this invention is where the copolymer composition comprises from 0.01 to 0.2 equivalents of a strong acid, relative to the equivalents of total carboxylic acid.

Another aspect of this invention is a curable composition comprising:
(1) a copolymer comprising as monomer units:
   (i) from 55 to 90 % by weight, based on the weight of said copolymer composition, of an ethylenically unsaturated carboxylic acid monomer, and
   (ii) from 10 to 30 % by weight, based on the weight of said copolymer composition, of a β-hydroxyalkylamide
      wherein the ratio of equivalents of said β-hydroxyalkylamide hydroxy functional groups to said carboxylic acid functional groups is from 0.05:1 to 1:1; and
(2) from 0.01 to 0.2 equivalents of a strong acid, relative to the equivalents of total carboxylic acid.

A preferred method for preparing a curable copolymer composition of this invention comprises the steps of: (i) reacting an ethylenically-unsaturated carboxylic acid anhydride monomer and a hydroxy-functional compound, to form a reaction product, wherein said reaction product is an ethylenically-unsaturated monomer which is polymerizable through radical polymerization; (ii) reacting said reaction product, in-situ, with an ethylenically-unsaturated carboxylic acid monomer.

The first step in the method of this invention is to react an ethylenically-unsaturated carboxylic acid anhydride monomer and a hydroxy-functional compound. Suitable ethylenically-unsaturated carboxylic acid anhydride monomers include, for example, maleic acid anhydride, itaconic acid anhydride, acrylic acid anhydride, methacrylic acid anhydride, ethacrylic acid anhydride, crotonic acid anhydride, cinnamic acid anhydride, citraconic acid anhydride, mesaconic acid anhydride, muconic acid anhydride, glutaconic acid anhydride, and the like, and mixtures thereof.

The hydroxy-functional compound that is reacted with the ethylenically-unsaturated carboxylic acid anhydride may be any hydroxy-functional compound capable of reacting with the ethylenically-unsaturated carboxylic acid anhydride monomers. Preferably, the hydroxy-functional compound is a polyol or an alkanolamine. "Polyol" means a polyhydric alcohol, i.e., one containing two or more hydroxyl groups. Where the hydroxy-functional compound is an alkanolamine, it is preferably a primary or secondary alkanolamine, or a polyol. Examples of suitable hydroxy-functional compounds include, for example, primary alkanolamines such as ethanolamine, isopropanolamine, 2-amino-1-propanol, 3-amino-1-propanol, 2-amino-1-butanol, and 4-amino-1-butanol, and the like; secondary alkanolamines such as diethanolamine, N-methylethanolamine, N-butylethanolamine, diisopropanolamine, N-methylisopropanolamine, di-n-butanolamine, and the like; polyols, such as for example, ethylene glycol, glycerol, pentaerythritol, trimethylol propane, sorbitol, sucrose, glucose, resorcinol, catechol, pyrogallol, glycollated ureas, 1,4-cyclohexane diol, polyvinyl alcohol, partially hydrolyzed polyvinyl acetate, and homopolymers or copolymers of hydroxyethyl (meth)acrylate, hydroxypropyl (meth)acrylate, 2-ethylaminoethanol, and the like; and combinations thereof. The hydroxy-functional compound preferably has a molecular weight of no greater than 1,000, more preferably no greater then 500, and even more preferably no greater than 300. In the preferred embodiment, the hydroxy-functional compound is a non-ethylenically-unsaturated compound.

The carboxylic acid anhydride is reacted with the hydroxy-functional compound, to form a reaction product. The reaction product is an ethylenically-unsaturated monomer that is polymerizable through radical polymerization. In a preferred embodiment of the invention, the reaction product is a β-hydroxyalkylamide. The reaction product preferably contains five equivalents of hydroxy-functional compound to one equivalent of anhydride, more preferably two equivalents of hydroxy-functional compound to one equivalent of anhydride, even more preferably one equivalent of hydroxy-functional compound to one equivalent of anhydride. Preferably, the copolymer composition contains as polymerized units, from 5 to 55 weight percent, more preferably from 10 to 40 weight percent, even more preferably from 10 to 30 weight percent, yet more preferably from 15 to 30 weight percent, of the reaction product.

An advantage of the β-hydroxyalkylamide reaction product is that it undergoes cyclization at elevated temperatures to form the imide. The presence of imide has been found to render the binder less prone to absorb water. As a result, the integrity of the curable coating is better maintained when exposed to liquid water or high atmospheric humidity.

The carboxylic acid anhydride and the hydroxy-functional compound can be reacted under any conditions suitable for preparing the reaction product. The reaction components may be added to the reaction vessel neat, or they may be added in the presence of a nonreactive solvent, such as, for example, an aromatic, such as for example, toluene or xylene; a ketone, such as for example, acetone or methyl ethyl ketone; an aliphatic, such as for example, heptane or octane; and the like, and combinations thereof. Preferably, the reaction is conducted under mild heating conditions, such as for example, temperatures of no greater than 100°C.

In one embodiment of the invention, the reaction of the carboxylic acid anhydride with the hydroxy-functional compound is conducted in the presence of an auxiliary base, such as, for example a tertiary alkanolamine, such as, for example, triethanolamine; a fixed base, such as for example, sodium hydroxide, potassium hydroxide, sodium carbonate, and the like; a volatile base, with the exception of ammonia, such as for example, volatile lower alkyl amines, and the like; and combinations thereof. "Auxiliary base" means a base in addition to any basic hydroxy-functional compound used in the reaction to form the reaction product. Any base may be used; however, bases that do not react with the carboxylic acid anhydride are preferred. The amount of water added with the base is preferably minimized to prevent hydrolysis of the carboxylic acid anhydride.

The reaction product is further reacted with an ethylenically-unsaturated carboxylic acid monomer. Examples of suitable monomers include, for example, methacrylic acid, acrylic acid, crotonic acid, fumaric acid, maleic acid, 2-methyl maleic acid, itaconic acid, 2-methyl itaconic acid, α,β-methylene glutaric acid, and the like, and combinations thereof. Preferably, the copolymer composition contains as polymerized units, from 40 to 95 weight percent, preferably from 55 to 90 weight percent, more preferably from 60 to 85 weight percent, of the carboxylic acid monomer.

In one embodiment of the process used in this invention, in addition to the ethylenically-unsaturated carboxylic acid monomer, the reaction product is also reacted with at least one ethylenically-unsaturated monomer having water solubility of less than 2g/100g water at 25°C. Examples of suitable monomers having a solubility in water of less than 2g/100g water at 25°C include, for example, ethyl methacrylate, ethyl acrylate, methyl methacrylate, butyl methacrylate, butyl acrylate, styrene, α-methyl styrene, mono-alkyl methacrylamide, mono-alkyl acrylamide, di-alkyl methacrylamide, di-alkyl acrylamide, and the like, and combinations thereof. The ethylenically-unsaturated monomer is preferably present in quantities of from about 3 to about 25 weight percent, more preferably from about 3 to about 20 weight percent, even more preferably from about 3 to about 15 weight percent, based on the total weight of monomer in the copolymer composition. The preferred amount of each of the ethylenically-unsaturated monomers is as follows: from about 10 to about 25 weight percent ethyl methacrylate or ethyl acrylate; from about 10 to about 20 weight percent methyl methacrylate; from about 3 to about 15 weight percent butyl methacrylate or butyl acrylate; from about 3 to about 15 weight percent styrene; from about 3 to about 15 weight percent α-methyl styrene; from about 3 to about 8 weight percent t-octyl acrylamide; and from about 5 to about 15 weight percent t-butyl acrylamide. In those embodiments of the invention in which the ethylenically-unsaturated monomer has a solubility in water of less than 1g/100g water at 25°C, it is preferred to use from about 3 to about 15 weight percent, based on the total weight of monomers in the copolymer composition, of the ethylenically-unsaturated monomer. In those embodiments of the invention in which the ethylenically-unsaturated monomer has a solubility in water of from 1g/100g to 2g/100 g water at 25°C, it is preferred to use from about 10 to about 25 weight percent, based on the total weight of monomers in the copolymer composition, of the ethylenically-unsaturated monomer. In one embodiment of the invention, the 3 to 25 weight percent ethylenically-unsaturated monomer is obtained by blending the copolymer composition with a different polymer composition.

The method provides a copolymer having a weight average molecular weight of from 1000 to 10,000,000. Preferred is a weight average molecular weight of less than 100,000; more preferred is a weight average molecular weight of less than 10,000, even more preferred is a weight average molecular weight of less than 5,000.

In a preferred embodiment of the method used to make a copolymer of this invention, the copolymer composition contains a strong acid. "Strong acid" means a non-carboxylic acid having at least one pKa of no greater than 3. In this embodiment, the copolymer composition preferably contains from 0.01 to 0.2 equivalents of a strong acid, relative to the equivalents of total carboxylic acid, more preferably from 0.01 to 0.18 equivalents. "Total carboxylic acid" means the entire amount of the carboxylic acid present in the copolymer composition. The strong acid may be a mineral acid, such as, for example, sulfuric acid, or an organic acid, such as, for example a sulfonic acid. Mineral acids are preferred. In this embodiment of the invention, it is preferred that the copolymer have a low molecular weight of preferably less than 10,000, more preferably less than 5,000, and even more preferably around 3,000 or less, with about 2,000 being advantageous.

Preferably, the pH of the composition is less than 3.5, more preferably less than 2.5, which pH will depend, among other things, on any auxiliary hydroxyl compound that may be employed, and the strength and amount of any strong acid or base that may be added.

In one embodiment of the invention, the composition further contains at least one low molecular weight polybasic carboxylic acid, anhydride or salt thereof having a molecular weight of 1000 or less, preferably 500 or less, and most preferably 200 or less. "Polybasic" means having at least two reactive acid or anhydride functional groups. Examples of suitable low molecular weight polybasic carboxylic acids and anhydrides include, for example, maleic acid, maleic anhydride, fumaric acid, succinic acid, succinic anhydride, sebacic acid, azelaic acid, adipic acid, citric acid, glutaric acid, tartaric acid, itaconic acid, trimellitic acid, hemimellitic acid, trimesic acid, tricarballytic acid, 1,2,3,4-butanetetracarboxylic acid, pyromellitic acid, oligomers of carboxylic acid, and the like. Optionally, the low molecular weight polybasic carboxylic acid, anhydride or salt thereof may be mixed with the hydroxyl-containing compound, under reactive conditions, prior to mixing with the polyacid copolymer.

In one embodiment of the invention, the composition further contains at least one auxiliary hydroxyl-containing compound. "Auxiliary hydroxyl-containing compound" means a hydroxyl-containing compound added to the composition after the reaction to form the copolymer. Suitable hydroxyl-containing compounds include those described hereinabove, as being suitable for reaction to form the reaction product. Additionally, tertiary alkanolamines may be used. Preferably, the ratio of the total number of equivalents of hydroxyl groups groups (ncluding hydroxyl groups from the copoplymer and the auxiliary-functional compound), to carboxylic acid groups, is preferably from 0.05:1 to 2:1, more preferably from 0.1:1 to 0.7:1, and even more preferably from 0.25:1 to 0.6:1.

In one embodiment of the invention, the copolymer composition is a solid composition such as, for example, a powder or a film. The solid composition may be obtained by various methods of drying, such as, for example spray drying, fluidized bed drying, freeze drying, and the like. In a preferred embodiment, the copolymer composition is a curable aqueous composition. "Aqueous", as used herein, includes water, and mixtures of water and water-miscible solvents. In this embodiment, the copolymer composition may be in the form of a solution of the copolymer composition in an aqueous medium, such as, for example, in the form of an aqueous dispersion, such as, for example, an emulsion-polymerized dispersion; or in the form of an aqueous suspension.

The copolymer composition may be prepared by free radical addition polymerization. In the embodiment of the invention where the composition is in the form of a solid, the copolymer can be prepared, for example, in a hot tube, either in the absence of solvent or with low levels of solvent for reduced viscosity. In other embodiments of the invention, the copolymer can be prepared by solution polymerization, emulsion polymerization, or suspension polymerization techniques for polymerizing ethylenically-unsaturated monomers, which are well known in the art. When it is desired to use emulsion polymerization, anionic or nonionic surfactants, or mixtures thereof, can be used. As noted above, the carboxylic acid is polymerized with the reaction product, and the optional ethylenically-unsaturated monomer having a solubility in water of less than 2g/100g water at 25°C, in an in-situ reaction. Therefore, the reaction product is present in the reaction kettle prior to addition of the other monomers. The polymerization can be carried out by various means such as, for example, with all of the monomers added to the reaction kettle prior to beginning the polymerization reaction, with a portion of the optional ethylenically-unsaturated monomer in emulsified form present in the reaction kettle at the beginning of the polymerization reaction, or with a small particle size emulsion polymer seed present in the reaction kettle at the beginning of the polymerization reaction.

The polymerization reaction to prepare the copolymer composition can be initiated by various methods known in the art such as, for example, by using the thermal decomposition of an initiator and by using an oxidation-reduction reaction ("redox reaction") to generate free radicals to effect the polymerization. In another embodiment the copolymer composition can be formed in the presence of phosphorous-containing chain transfer agents such as, for example, hypophosphorous acid and its salts, as is disclosed in U.S. Patents No. 5,077,361 and 5,294,686, so as to incorporate a phosphorous-containing species in the polymer backbone. The copolymer composition can be prepared in solvent/water mixtures such as, for example, i-propanol/water, tetrahydrofuran/water, and dioxane/water.

In certain embodiments, the copolymer composition can include an accelerator. As noted above, the accelerator may be present during the in-situ reaction of the reaction product with the carboxylic acid monomer. Alternatively, the accelerator may be added to the copolymer composition after completion of the in-situ reaction. Examples of suitable accelerators include phosphorous-containing species which can be a phosphorous-containing compound such as, for example, an alkali metal hypophosphite salt, hypophosphorous acid, an alkali metal phosphite, an alkali metal polyphosphate, an alkali metal dihydrogen phosphate, a polyphosphoric acid, and an alkyl phosphinic acid or it can be an oligomer or polymer bearing phosphorous-containing groups such as, for example, an addition polymer of acrylic and/or maleic acid formed in the presence of sodium hypophosphite, addition polymers such as, for example, the copolymer of the present invention prepared from ethylenically-unsaturated monomers in the presence of phosphorous salt chain transfer agents or terminators, and addition polymers containing acid-functional monomer residues such as, for example, copolymerized phosphoethyl methacrylate, and like phosphonic acid esters, and copolymerized vinyl sulfonic acid monomers, and their salts. The phosphorous-containing species can be used at a level of from 0% to 40%, preferably from 0% to 20%, further preferably from 0% to 15%, more preferably from 0% to 10% by weight based on the weight of the copolymer of the invention.

Chain transfer agents such as mercaptans, polymercaptans, and halogen compounds can be used in the polymerization mixture in order to moderate the molecular weight of the copolymer composition. Generally, from 0% to 10% by weight, based on the weight of the polymeric binder, of C₄ - C₂₀ alkyl mercaptans, mercaptopropionic acid, or esters of mercaptopropionic acid, can be used.

The carboxyl groups of the copolymer composition may be neutralized with a base. The base may be added before, during, or after polymerization of the reaction product with the carboxylic acid to form the copolymer composition. The neutralization may at least partially occur prior to, or while treating a substrate.

In one embodiment of the invention, the carboxyl groups of the copolymer composition may be neutralized with a fixed base, meaning a base which is substantially nonvolatile under the conditions of the treatment such as, for example, sodium hydroxide, potassium hydroxide, sodium carbonate, or t-butylammonium hydroxide. The fixed base must be sufficiently nonvolatile that it will substantially remain in the composition during heating and curing operations.

In a different embodiment of the invention, the carboxy groups may be neutralized with a volatile base, meaning a base which is substantially volatile under the conditions of treatment of the substrate with the copolymer composition. Suitable volatile bases for neutralization include, for example, ammonia or volatile lower alkyl amines. The volatile base can be used in addition to the fixed base. Fixed multivalent bases such as, for example, calcium carbonate can tend to destabilize an aqueous dispersion, if the copolymer composition is used in the form of an aqueous dispersion; but can be used in minor amount.

When the copolymer composition is in the form of an aqueous dispersion or an aqueous suspension and low levels of precrosslinking or gel content are desired, low levels of multi-ethylenically-unsaturated monomers such as, for example, allyl methacrylate, diallyl phthalate, 1,4-butylene glycol dimethacrylate, 1,6-hexanedioldiacrylate, and the like, can be used at a level of from 0.01% to 5 %, by weight based on the weight of copolymer.

When the copolymer composition is in the form of an aqueous dispersion, the diameter of the copolymer particles can be from 80 nanometers to 1000 nanometers, as measured using a Brookhaven BI-90 Particle Sizer, which employs a light scattering technique. However, polymodal particle size distributions such as those disclosed in US Patent Nos. 4,384,056 and 4,539,361, hereby incorporated herein by reference, can be employed.

When the copolymer composition is in the form of an aqueous dispersion, the copolymer particles can be made up of two or more mutually incompatible copolymers. These mutually incompatible copolymers can be present in various morphological configurations such as, for example, core/shell particles, core/shell particles with shell phases incompletely encapsulating the core, core/shell particles with a multiplicity of cores, interpenetrating network particles, and the like.

In one embodiment of the present invention, a macromolecular organic compound having a hydrophobic cavity is present in the polymerization medium used to form the copolymer composition. Suitable techniques for using a macromolecular organic compound having a hydrophobic cavity are disclosed in, for example, U.S. Patent No. 5,521,266. Macromolecular organic compounds having a hydrophobic cavity useful in the present invention include, for example, cyclodextrin or cyclodextrin derivatives; cyclic oligosaccharides having a hydrophobic cavity such as cycloinulohexose, cycloinuloheptose, or cycloinuloctose; calyxarenes; cavitands; or combinations thereof. Preferably, the macromolecular organic compound is β-cyclodextrin, more preferably methyl-β-cyclodextrin.

In one embodiment of the invention, the binder composition is blended with an emulsion polymer including, as polymerized units, at least one copolymerized ethylenically-unsaturated nonionic acrylic monomer. "Emulsion polymer" means a polymer dispersed in an aqueous medium that has been prepared by emulsion polymerization techniques known in the art. By "nonionic monomer" herein is meant that the copolymerized monomer residue does not bear an ionic charge between pH=1-14.

The ethylenically-unsaturated nonionic acrylic monomers include, for example, (meth)acrylic ester monomers including methyl acrylate, ethyl acrylate, butyl acrylate, 2-ethylhexyl acrylate, decyl acrylate, lauryl acrylate, methyl methacrylate, butyl methacrylate, isodecyl methacrylate, lauryl methacrylate; hydroxyalkyl(meth)acrylate monomers such as 2-hydroxyethyl methacrylate, 2-hydroxyethyl acrylate, 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate and 2-hydroxybutyl acrylate. Other ethylenically-unsaturated nonionic monomers which may be incorporated into the polymer include vinylaromatic compounds, such as styrene, α-methylstyrene, p-methylstyrene, ethylvinylbenzene, vinylnaphthalene, vinylxylenes, vinyltoluenes, and the like; vinyl acetate, vinyl butyrate and other vinyl esters; vinyl monomers such as vinyl alcohol, vinyl chloride, vinyl toluene, vinyl benzophenone, and vinylidene chloride.

Further ethylenically-unsaturated nonionic acrylic monomers include acrylamides and alkyl-substituted acrylamides, such as acrylamide, methacrylamide, N-tert-butylacrylamide and N- methyl(meth)acrylamide; hydroxyl-substituted acrylamides, such as methylolacrylamide, and beta-hydroxyalkylamides.

The emulsion polymer may contain monoethylenically-unsaturated acid monomer, such as, for example, acrylic acid, methacrylic acid, crotonic acid, itaconic acid, fumaric acid, maleic acid, monomethyl itaconate, monomethyl fumarate, monobutyl fumarate, maleic anhydride, 2-acrylamido-2-methylpropane sulfonic acid, vinyl sulfonic acid, styrene sulfonic acid, 1-allyloxy-2-hydroxypropane sulfonic acid, alkyl allyl sulfosuccinic acid, sulfoethyl (meth)acrylate, phosphoalkyl (meth)acrylates such as phosphoethyl (meth)acrylate, phosphopropyl (meth)acrylate, and phosphobutyl (meth)acrylate, phosphoalkyl crotonates, phosphoalkyl maleates, phosphoalkyl fumarates, phosphodialkyl (meth)acrylates, phosphodialkyl crotonates, and allyl phosphate.

The emulsion polymer used in this invention may contain copolymerized multi-ethylenically-unsaturated monomers such as, for example, allyl methacrylate, diallyl phthalate, 1,4-butylene glycol dimethacrylate, 1,2-ethylene glycol dimethacrylate, 1,6-hexanediol diacrylate, butadiene, and divinyl benzene.

In a further embodiment of the invention, the copolymer composition is blended with a predominately hydrophobic emulsion polymer including, as polymerized units, greater than 30%, preferably greater than 40%, more preferably greater than 50%, and even more preferably greater than 60%, by weight, based on the weight of the emulsion polymer solids, of an ethylenically-unsaturated acrylic monomer including a C₅ or greater alkyl group. "Acrylic monomer including a C₅ or greater alkyl group" means an acrylic monomer bearing an aliphatic alkyl group having five or more C atoms, the alkyl group including n-alkyl, s-alkyl, i-alkyl, and t-alkyl groups. Suitable ethylenically-unsaturated monomers including a C₅ or greater alkyl group include (C₅-C₃₀) alkyl esters of (meth)acrylic acid, such as amyl (meth)acrylate, 2-ethylhexyl (meth)acrylate, benzyl (meth)acrylate, lauryl (meth)acrylate, oleyl (meth)acrylate, palmityl (meth)acrylate, stearyl (meth)acrylate; unsaturated vinyl esters of (meth)acrylic acid such as those derived from fatty acids and fatty alcohols; surfactant monomers including long chain alkoxy- or alkylphenoxy(polyalkylene oxide) (meth)acrylates, such as C₁₈H₃₇-(ethylene oxide)₂₀ methacrylate and C₁₂H₂₅-(ethylene oxide)₂₃ methacrylate; N-alkyl substituted (meth)acrylamides such as octyl acrylamide; and the like. The.monomer including a C₅ or greater alkyl group can also contain functionality, such as amido, aldehyde, ureido, polyether and the like, but preferably does not contain an acid or hydroxy group. Emulsion polymers containing such monomers can be prepared by emulsion polymerization, preferably by the method for forming polymers of U.S. Patent No. 5,521,266. A surfactant may be added to the emulsion polymer before or during the blending of the emulsion polymer with the copolymer composition. Preferably, the surfactant is added in the amount of from 0.5% to 20%, preferably from 2% to 10%, by weight, based on the weight of emulsion polymer solids. Preferred is a surfactant having a HLB value of greater than 15.

The predominately hydrophobic emulsion polymer can also include, as copolymerized units, from 0% to 10%, preferably from 0% to 5%, by wt based on the weight of the emulsion polymer solids, monomer bearing a carboxylic acid group, anhydride group, or salt thereof or hydroxyl-group, such as (meth)acrylic acid and hydroxyethyl(meth)acrylate. The emulsion polymer may be present in an amount of from 1% to 10%, preferably from 1.5% to 5%, by weight based on the weight of the copolymer composition, on a solids basis.

The ratio of the number of equivalents of hydroxy functional groups of the monomer reaction product, to acid functional groups of the carboxylic acid monomer, is preferably from 0.05:1 to 2:1, more preferably from 0.1:1 to 0.7:1, and even more preferably from 0.25:1 to 0.6:1.

The copolymer composition can contain, in addition, conventional treatment components such as, for example, emulsifiers; pigments; fillers or extenders; anti-migration aids; curing agents; coalescents; surfactants, particularly nonionic surfactants; spreading agents; mineral oil dust suppressing agents; biocides; plasticizers; organosilanes; antifoaming agents such as dimethicones, silicone oils and ethoxylated nonionics; corrosion inhibitors, particularly corrosion inhibitors effective at pH<4 such as thioureas, oxalates, and chromates; colorants; antistatic agents; lubricants; waxes; anti-oxidants; coupling agents such as silanes, particularly SilquestTM A-187 (manufactured by GE Silicones--OSi Specialties, located in Wilton CT); polymers not of the present invention; and waterproofing agents such as silicones and emulsion polymers, particularly hydrophobic emulsion polymers containing, as copolymerized units, greater than 30% by weight, based on the weight of the emulsion polymer solids, ethylenically-unsaturated acrylic monomer containing a C5 or greater alkyl group.

The copolymer composition of this invention is preferably a formaldehyde-free copolymer composition. "Formaldehyde-free composition" means that the composition is substantially free from formaldehyde, nor does it liberate substantial formaldehyde as a result of drying and/or curing. To minimize the formaldehyde content of the copolymer composition it is preferred, when preparing a polymer of the present invention, to use polymerization adjuncts such as, for example, initiators, reducing agents, chain transfer agents, biocides, surfactants, and the like, which are themselves free from formaldehyde, do not generate formaldehyde during the polymerization process, and do not generate or emit formaldehyde during the treatment of a substrate. "Substantially free from formaldehyde" means that when low levels of formaldehyde are acceptable in the waterborne composition or when compelling reasons exist for using adjuncts which generate or emit formaldehyde, substantially formaldehyde-free waterborne compositions can be used.

The copolymer composition prepared by the method of the invention may be used for treating a substrate. Such treatments can be commonly described as, for example, coating, sizing, saturating, bonding, combinations thereof, and the like. Typical substrates include wood, including, for example, solid wood, wood particles, fibers, chips, flour, pulp, and flakes; metal; plastic; fibers such as glass fibers; woven and non-woven fabrics; and the like. The copolymer composition can be applied to a substrate by conventional techniques such as, for example, air or airless spraying, padding, saturating, roll coating, curtain coating, beater deposition, coagulation, or the like.

In one embodiment of this invention, the copolymer composition can be used as a binder for heat-resistant non-woven fabrics such as, for example, non-wovens which contain heat-resistant fibers such as, for example, aramid fibers, ceramic fibers, metal fibers, carbon fibers, polyimide fibers, certain polyester fibers, rayon fibers, rock wool, and glass fibers. "Heat-resistant fibers" mean fibers which are substantially unaffected by exposure to temperatures above 125°C. Heat-resistant non-wovens can also contain fibers which are not in themselves heat-resistant such as, for example, certain polyester fibers, rayon fibers, nylon fibers, and super-absorbent fibers, in so far as they do not materially adversely affect the performance of the substrate.

Non-woven fabrics are composed of fibers which can be consolidated by purely mechanical means such as, for example, by entanglement caused by needle-punching, by an air-laid process, and by a wet-laid process; by chemical means such as, for example, treatment with a polymeric binder; or by a combination of mechanical and chemical means before, during, or after non-woven fabric formation. Some non-woven fabrics are used at temperatures substantially higher than ambient temperature such as, for example, glass fiber-containing non-woven fabrics which are impregnated with a hot asphaltic composition pursuant to making roofing shingles or roll roofing material. When a non-woven fabric is contacted with a hot asphaltic composition at temperatures of from 150°C to 250°C, the non-woven fabric can sag, shrink, or otherwise become distorted. Therefore, non-woven fabrics which incorporate a copolymer composition should substantially retain the properties contributed by the cured aqueous composition such as, for example, tensile strength. In addition, the cured composition should not substantially detract from essential non-woven fabric characteristics, as would be the case, for example, if the cured composition were too rigid or brittle or became sticky under processing conditions.

The copolymer aqueous composition, after it is applied to a substrate, is heated to effect drying and curing. The duration and temperature of heating will affect the rate of drying, processability, handleability; and property development of the treated substrate. Heat treatment at from 120 °C to 400 °C for a period of time between from 3 seconds to 15 minutes can be carried out; treatment at from 175 °C to 225 °C. is preferred. By "curing" is meant herein a chemical or morphological change which is sufficient to alter the properties of the polymer such as, for example, via covalent chemical reaction, ionic interaction or clustering, improved adhesion to the substrate, phase transformation or inversion, hydrogen bonding, and the like. The drying and curing functions can be performed in two or more distinct steps, if desired. For example, the composition can be first heated at a temperature and for a time sufficient to substantially dry but not to substantially cure the composition, and then heated for a second time at a higher temperature and/or for a longer period of time to effect curing. Such a procedure, referred to as "B-staging", can be used to provide binder-treated nonwoven, for example, in roll form, which can at a later stage be cured, with or without forming or molding into a particular configuration, concurrent with the curing process.

The heat-resistant non-wovens can be used for applications such as, for example, insulation batts or rolls, as reinforcing mat for roofing or flooring applications, as roving, as microglass-based substrate for printed circuit boards or battery separators, as filter stock, as tape stock, and as reinforcement scrim in cementitious and non-cementitious coatings for masonry, in ceiling tiles, cellulosic roofing tiles, window treatments, wall coverings, molded parts, for curly pulp modification, for powder coating, and the like.

The following examples are intended to illustrate copolymers and the method of preparing the copolymer composition.

### Example 1: Reaction Product 1 Solution

To a 3L flask equipped with a condenser, a thermocouple, and a mechanical stirrer was added 210 grams (2 moles) of diethanolamine and 298 grams (2 moles) of triethanolamine. A nitrogen atmosphere was established in the flask, and the initial contents were heated to 85°C with stirring. Then 196 gram (2 moles) of maleic anhydride powder was added in small portions over the course of an hour. After addition of the maleic anhydride was complete the mixture was stirred for an additional hour at 85 °C. At the end of that hour 704 grams of deionized water was added and the resulting product was cooled to room temperature.

### Example 2: Reaction Product 2 Solution

To a 3L flask equipped with a condenser, a thermocouple, and a mechanical stirrer was added 210 grams (2 moles) of diethanolamine and 148 grams (1 mole) of triethanolamine and 54 grams (0.5 mole) of sodium carbonate. A nitrogen atmosphere was established in the flask, and the initial contents were heated to 85 °C with stirring. Then 196 gram (2 moles) of maleic anhydride powder was added in small portions over the course of an hour. After addition of the maleic anhydride was complete, the mixture was stirred for an additional hour at 85°C. At the end of that hour, 608 grams of deionized water was added, and the resulting product was cooled to room temperature.

### Example 3: Reaction Product 3 Solution

To a 3L flask equipped with a condenser, a thermocouple, and a mechanical stirrer was added 210 grams (2 moles) of diethanolamine and 106 grams (1 mole) of sodium carbonate. A nitrogen atmosphere was established in the flask and the initial contents were heated to 85 °C with stirring. Then 196 gram (2 moles) of maleic anhydride powder was added in small portions over the course of an hour. After addition of the maleic anhydride was complete the mixture was stirred for an additional hour at 85 °C. At the end of that hour 512 grams of deionized water was added and the resulting product was cooled to room temperature.

### Example 4: Reaction Product 4 Solution

To a 1 L flask equipped with a condenser, a thermocouple, and a mechanical stirrer was added 105 grams (1 mole) of diethanolamine. A nitrogen atmosphere was established in the flask and the initial contents were heated to 55 °C with stirring. Then 98 grams (1 mole) of maleic anhydride powder was added in small portions over the course of an hour. After addition of the maleic anhydride was complete the mixture was stirred for an additional hour at 55 °C. At the end of that hour 203 grams of deionized water was added and the resulting product was cooled to room temperature.

### Example 5: 73.5AA/26.4 Reaction Product 1

To a 2L flask equipped with a condenser, a thermocouple, and a mechanical stirrer was added a 345 gram portion of the solution prepared in Example 1, 271 grams of deionized water, and 21.3 grams of sodium hypophosphite. A nitrogen atmosphere was established in the flask, and the initial contents were heated to 92°C, with stirring. Once the flask contents reached 92°C, a solution of 0.7 grams of sodium persulfate in 7.5 grams deionized water was added. Acrylic acid (276.7 grams), and a separate solution of 6.4 grams of sodium persulfate in 11.8 grams of deionized water, were gradually added to the reaction flask over 2 hours, while the temperature was maintained at 94°C. During the gradual addition of the acrylic acid and the sodium persulfate solution, a separate solution of 21.3 grams of sodium hypophosphite in 26 grams of deionized water was also gradually added over the course of 105 minutes. Once the acrylic acid and sodium persulfate solution was completely added, the reaction mixture was held at 94°C for 30 minutes, and then cooled to room temperature. The resulting copolymer solution had a solids content of 47.8 % and a pH of 4.2.

### Examples 6-11

The procedure of Example 5 was repeated with the changes shown in the table below.

| | Composition¹ | Wt AA (grams) | Wt Reaction Product 1 Solution (Example 1) (grams) | Wt Reaction Product 2 Solution (Example 2) (grams) | Wt Reaction Product 3 Solution (Example 3) (grams) | Wt Initial Water (grams) |
|---|---|---|---|---|---|---|
| Example 6 | 77.4AA/22.6 Rxn Product 1 | 298.3 | 301.9 | | | 271 |
| Example 7 | 83.0AA/17.0 Rxn Product 1 | 331.1 | 236.3 | | | 301 |
| Example 8 | 74.1AA/25.9 Rxn Product 2 | 294.7 | | 309.1 | | 301 |
| Example 9 | 77.4AA/22.6 Rxn Product 2 | 312.6 | | 273.1 | | 301 |
| Example 10 | 83.0AA/17.0 Rxn Product 2 | 343.6 | | 211.1 | | 301 |
| Example 11 | 48.7AA/51.3 Rxn Product 3 | 193.2 | | | 512 | 186 |

| | | | | | | |
|---|---|---|---|---|---|---|
| ¹(AA/β-hydroxyalkylamide monomer) | | | | | | |

## Claims

1. A curable copolymer composition comprising as monomer units:
(i) from 55 to 90 % by weight, based on the weight of said copolymer composition, of an ethylenically-unsaturated carboxylic acid monomer, and
(ii) from 10 to 30 % by weight, based on the weight of said copolymer composition, of a β-hydroxyalkylamide
wherein said β-hydroxyalkylamide has been formed by the reaction of an ethylenically-unsaturated carboxylic acid anhydride monomer and an alkanolamine,
wherein the ratio of equivalents of said β-hydroxyalkylamide hydroxy functional groups to said carboxylic acid functional groups is from 0.05:1 to 1:1.

2. The composition of claim 1, wherein said β-hydroxyalkylamide has been reacted in-situ with said ethylenically unsaturated carboxylic acid monomer.

3. The composition of claim 1, wherein said alkanolamine is selected from the group consisting of primary alkanolamine, secondary alkanolamine, and polyol.

4. The composition of claim 1, wherein said composition further comprises at least one auxilary hydroxy-functional compound, wherein the ratio of the total number of equivalents of hydroxyl groups (ncluding hydroxyl groups from the copoplymer and the auxiliary-functional compound), to carboxylic acid groups, is from 0.05:1 to 2:1.

5. The composition of claim 4, wherein the ratio of the total number of equivalents of hydroxyl groups is from 0.1:1 to 0.7:1.

6. The composition of claim 4, wherein the ratio of the total number of equivalents of hydroxyl groups is preferably from 0.25:1 to 0.6:1..

7. The composition of claim 1, wherein said anhydride and said alkanolamine have been reacted in the presence of an auxiliary base.

8. The composition of claim 1, wherein said alkanolamine has a molecular weight of no greater than 1,000.

9. The composition of claim 1, wherein said alkanolamine compound is not ethylenically-unsaturated.

10. The composition of claim 1, wherein said copolymer composition further comprises at least one ethylenically-unsaturated monomer having a solubility in water of less than 2g/100g water at 25°C.
